## Europäisches Patentamt

## European Patent Office

## Office européen des brevets

(11) Publication number: **0 127 724**
**B1**

# EUROPEAN PATENT SPECIFICATION

(45) Date of publication of patent specification: **06.12.89**

(51) Int. Cl.⁴: **H 01 L 31/10**

(21) Application number: **84100779.2**

(22) Date of filing: **26.01.84**

(54) **Photodetector.**

(30) Priority: **02.06.83 US 500502**

(43) Date of publication of application:
**12.12.84 Bulletin 84/50**

(45) Publication of the grant of the patent:
**06.12.89 Bulletin 89/49**

(84) Designated Contracting States:
**DE FR GB**

(56) References cited:
**EP-A-0 023 723**
**US-A-3 889 284**
**US-A-3 995 303**
**US-A-4 053 920**
**US-A-4 171 996**
**US-A-4 206 002**
**US-A-4 250 515**

**IEEE TRANSACTIONS ON ELECTON DEVICES,
vol. ED-30, no. 4, April 1983, pages 381-390,
IEEE, New York, US; F. CAPASSO et al.:
"Staircase solid-state photomultipliers and
avalanche photodiodes with enhanced
ionization rates ratio"**

**IEEE JOURNAL OF SOLID-STATE CIRCUITS,
vol. SC-13, no. 1, February 1978, pages 139-158,**

(73) Proprietor: **International Business Machines
Corporation
Old Orchard Road
Armonk, N.Y. 10504 (US)**

(72) Inventor: **Chang, Leroy Li-Gong
Manor Drive PO Box 548
Goldens Bridge New York 10526 (US)**
Inventor: **Fang, Frank Fu
1691 Cardinal Court
Yorktown Heights New York 10598 (US)**

(74) Representative: **Blake, John
IBM United Kingdom Limited Intellectual
Property Department Hursley Park
Winchester Hampshire SO21 2JN (GB)**

(56) References cited:
**IEEE, New York, US; J.T. LONGO et al.:
"Infrared focal planes in intrinsic
semiconductors"**

Courier Press, Leamington Spa, England.

## Description

This invention relates to semiconductor photodetectors which convert light energy to electrical signals.

Efficiency in conversion of a band of wavelengths can be achieved with photodetectors comprising multiple layers wherein each layer responds to a different wavelength of light.

One such device is described in US—A—4 206 002 which shows a monocrystalline structure with a plurality of p and n portions and a gradually changing composition providing a graded band gap.

It has been found that as the interface between layers becomes more abrupt impact ionization will provide a multiplication effect.

US—A—3,995,303 and 4,250,516 each show such multilayer structures wherein there is a relatively abrupt transition between regions that product impact ionization as the dominant mechanism for carriers. One of the disadvantages however with the impact ionization mechanism is that considerable noise is generated which degrades the performance of the photodetector.

According to the invention, a photodetector is provided comprising monocrystalline semiconductor body having a plurality of p and n conducting type layers and a progressively decreasing band gap in a direction away from the light incident surface of the body, in which a transparent electrode is provided on the layer with the largest band gap and a contact on the back surface of the body, in order to apply a bias and to conduct the output signal, characterised in that said body is composed of a plurality of step graded layers responsive to different light energies, each of a thickness of the order of the absorption length of the wavelength in the incident light that is to be absorbed by that particular layer, whose band gap decreases in a series of steps with the predominant change being in the band conduction or valence band that favours a particular type (electrons or holes) of charge carrier such that energy is transferred mainly to this predominant carrier, each step being such that substantially the entire transition occurs over a distance less than the mean free path of the said carrier.

How the invention can be carried out will now be described by way of example, with reference to the accompanying drawings, in which:—

Fig. 1 is a schematic illustration of a five stage semiconductor photodetector in accordance with the invention;

Fig. 2 is a band energy diagram of the material $(In_xGa_{1-x})As$, dimensionally correlated with Fig. 1.

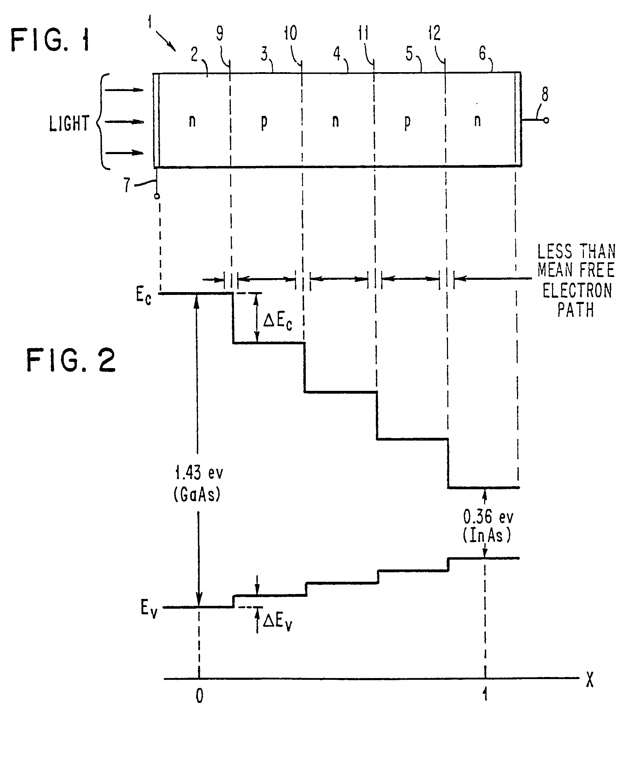

A monocrystalline semiconductor body 1 (Fig. 1), consists of a series of five progressively lower band gap regions 2, 3, 4, 5 and 6. While five regions are shown, more or less may be used to convert as many wavelengths in the band of incident light as is desired. A transparent electrode 7 is provided on an incident surface of region 2 and an ohmic contact 8 is provided on the back surface of the region 6 in order to apply a bias and to conduct the output signal.

Each region 2 through 6 is of a thickness of the order of the absorption length of the wavelength in the incident light that is to be absorbed by that particular layer.

The structure is designed so that there is an abrupt interface, shown as dotted lines 9, 10, 11 and 12 between each pair of adjacent regions. Each of the heterojunction interfaces is such that the entire transition occurs over a distance of the order of the mean free path of the predominant carrier.

In order to facilitate explanation, the description will be provided in terms of particular semiconductor materials and specifications but it will be readily apparent in the light of the principles set forth that other materials and specifications can be employed.

The preferred material where the predominant carriers are electrons is $(In_xGa_{1-x})As$. GaAs has a band gap of 1.43 electron volts and the band gap decreases with increases in x of Indium to 0.36 electron volts for InAs. The material has band gap variation asymmetry in that the majority of the difference in band gap is in the conduction band. The step transition at each interface is within the mean free path of the carriers in most materials and is of the order of and preferably less than 5 nm (50 Å).

Referring next to Fig. 2 which is an energy band diagram dimensionally correlated with the structure of Fig. 1, the region 2 has the widest band gap and there is an abrupt, that is within less than 5 nm (50 Å) change $\Delta E_c + \Delta E_v$ at each of the interface regions 9, 10, 11 and 12 to progressively smaller band gaps with the region 6 having the smallest band gap.

In the preferred material where the dominant carriers are to be electrons the region 2 is pure GaAs with an energy gap of 1.43 eV. At the interface or heterojunction 9, there is an abrupt change to $(Ga_{.75}In_{.25})As$ and the abrupt change at the interface 9 occurs within a distance of about 5 nm (50 Å) so that no inelastic scattering will take place in this transition region. Thus, the photogenerated electrons in traversing from region 2 to region 3 will gain kinetic energy equivalent to the change in conduction band $(\Delta E_c)$. This kinetic energy gain is the predominant mechanism for carrier multiplication by impact ionization. There will be a similar gain of kinetic energy between successive steps at the interface regions 9, 10, 11 and 12. In the interface region 10 between regions 3 and 4, there is an abrupt change to $(Ga_{0.5}In_{0.5})As$ and in the interface region 11 there is an abrupt change to $(Ga_{0.25}In_{.75})As$ and lastly, in the interface region 12 the material would change to pure InAs. As may be seen from the line at the bottom of Fig. 2, the In variable x increases in the direction away from the light incident surface of the crystal.

Referring further to Fig. 2, the $\Delta E_c$ in the energy diagram is greater than $\Delta E_v$. This provides a built-in asymmetry which favours electrons as carriers.

In other words, $\Delta E_c$ is substantially greater than $\Delta E_v$ for this $(In_xGa_{1-x})As$ material so that the energy gain by the carriers that traverse the entire region is much greater for electrons than for holes. The asymmetry that favours a particular type of carrier is a property that at this point in the art has not been reported as being predictable from other properties of the material however it can be readily measured. In ternary compounds of the type $(A_xB_{1-x})C$, it is preferable that the energy band discontinuity be at least a two-to-one change favouring the predominant carrier. In other words, for electrons $\Delta E_c$ should be at least twice $\Delta E_v$. The condition for predominately one carrier operation is true with or without external bias, although the presence of an external bias applied between contacts 7 and 8 will enhance the operation.

In the carrier multiplication regime, the probability of ionization by electrons is much higher than that by holes where the greater change in band energy is in the conduction band rather than in the valence band. This will be of particular value in reducing noise. Since a noise figure associated with a carrier multiplication factor of M is proportional to $M^3$ and $M^2$, where $M^3$ is the figure for electrons and holes whereas $M^2$ is the figure for only electrons or holes. For photodetectors operating in the impact ionization or avalanche mode, M will always be greater than unity.

Thus, the structure of the invention will offer a much improved signal to noise ratio compared with conventional homojunction devices and it will have comparable ionization rates for electrons or holes.

While the structure thus far has been described for convenience in terms of electrons being the predominant carrier, the principles of the invention may be applied by one skilled in the art readily to a structure involving holes as the dominant ionized carrier. For this purpose, a different $(A_xB_{1-x})C$ material would be chosen. The criteria would be the difference in band gap as A and B are varied and the asymmetry would be such that most of the change would be in the valence band. An example material is $Ga(Sb_xAs_{1-x})$. Here, the energy gap would vary from 1.43 eV for GaAs to 0.81 eV for GaSb and the difference would occur almost entirely in the valence band, in other words, $\Delta E_v$ would be at least twice as great as $\Delta E_c$.

The structures can be conveniently fabricated by the technique of molecular beam epitaxy which is favoured because of its demonstrated capability of growing high quality thin films of precise composition and thickness with smooth and abrupt interfaces although any technique wherein the interface could be achieved within a distance of less than 5 nm (50 Å) would be sufficient to produce the desired features desired.

What has been described is a semiconductor structure wherein photogenerated carriers are amplified by impact ionization in a very abrupt interface and a particular type of predominant carrier is favoured by an asymmetry in the variation in band gap. The impact ionization process is greatly enhanced by the carriers gaining kinetic energy at the successive heterojunction steps which have transition regions less than the carrier mean free path. The successively varied gap in these heterostructures further provides high quantum efficiency for a broad spectrum of optical signals.

## Claims

1. A photodetector comprising a monocrystalline semiconductor body (1) having a plurality of p and n conducting type layers (2—6) and a progressively decreasing band gap in a direction away from the light incident surface of the body, in which a transparent electrode (7) is provided on the layer with the largest band gap (2) and a contact (8) on the back surface (6), of the body, in order to apply a bias and to conduct the output signal, characterised in that said body is composed of a plurality of step graded layers (2—6) responsive to different light energies, each of a thickness of the order of the absorption length of the wavelength in the incident light that is to be absorbed by that particular layer, whose band gap decreases in a series of steps with a predominant change being in the band conduction or valence band that favours a particular type (electrons or holes) of charge carrier such that energy is transferred mainly to this predominant carrier, each step being such that substantially the entire transition occurs over a distance less than the mean free path of the said carrier.

2. A photodetector as claimed in claim 1, wherein the favoured charge carriers are the electrons and the conduction band discontinuity is larger than the valence band discontinuity at each of said steps.

3. A photodetector as claimed in claim 1, wherein the favoured charge carriers are the holes and the valence band discontinuity is substantially larger than the conduction band discontinuity at each of the said steps.

4. A photodetector as claimed in claim 2, wherein the semiconductor body is of $(In_xGa_{1-x})As$, where x varies from 0 to 1 in steps of approximately 0.25.

5. A photodetector as claimed in claim 3, wherein the semiconductor body if of $Ga(Sb_xAs_{1-x})$, where x varies from 0 to 1 in steps of approximately 0.25.

6. A photodetector as claimed in any preceding claim, in which each transition in the band gap occurs within 5 nm.

## Patentansprüche

1. Photodetektor mit einem monokristallinen Halbleiterkörper (1), welcher eine Anzahl von p- und n-leitenden Schichten (2—6) und einen in einer Richtung weg von der Lichteinfallsfläche des Körpers fortschreitend abnehmenden Bandabstand aufweist, wobei in dem Körper eine transparente Elektrode (7) auf der Schicht mit dem größten Bandabstand (2) und ein Kontakt (8) auf der Rückfläche (6) des Körpers zur Aufgabe einer Vorspannung und zum Führen des Ausgangssignals vorgesehen ist, dadurch gekennzeichnet, daß der Körper aus einer Anzahl von auf verschiedene Lichtenergien ansprechenden abgestuften Schichten (2—6) aufgebaut ist, jede von einer Dicke der Größenordnung der Absorptionslänge der Wellenlänge im einfallenden Licht, die von eben dieser Schicht absorbiert werden soll, deren Bandabstand in einer Folge von Stufen abnimmt, wobei die überwiegende Änderung in dem Band (Leitungs- oder Valenzband) vorliegt, das eine bestimmte Art (Elektronen oder Löcher) von Ladungsträgern begünstigt, so daß Energie hauptsächlich auf diesen überwiegenden Träger übertragen wird, wobei jede Stufe so ist, daß im wesentlichen der gesamte Übergang über einen Abstand passiert, der geringer als die mittlere freie Weglänge des Ladungsträgers ist.

2. Photodetektor nach Anspruch 1, bei welchem die begünstigten Ladungsträger die Elektronen sind und die Leitungsbanddiskontinuität größer als die Valenzbanddiskontinuität an jeder der Stufen ist.

3. Photodetektor nach Anspruch 1, bei welchem die begünstigten Ladungsträger die Löcher sind und die Valenzbandkontinuität wesentlich größer als die Leitungsbanddiskontinuität an jeder der Stufen ist.

4. Photodetektor nach Anspruch 2, bei welchem der Halbleiterkörper aus $(In_xGa_{1-x})As$ ist, wobei x zwischen 0 und 1 in Schritten von ungefähr 0,25 variiert.

5. Photodetektor nach Anspruch 2, bei welchem der Halbleiterkörper aus $Ga(Sb_xAs_{1-x})$ ist, wobei x von 0 bis 1 in Schritten von ungefähr 0,25 variiert.

6. Halbleiterkörper nach irgendeinem vorstehenden Anspruch, bei welchem jeder Übergang im Bandabstand innerhalb 5 nm auftritt.

## Revendications

1. Un photodétecteur comportant un corps semiconducteur monocristallin (1) avec une pluralité de couches de type de conductivité p et n (2 à 6) et une bande interdite diminuant progressivement au fur et à mesure que l'on s'éloigne de la surface du corps qui reçoit la lumière, ce photodétecteur étant pourvu d'une électrode transparente (7) formée sur la couche ayant la bande interdite la plus large (2) et d'un contact (8) formé au dos du corps (6), de manière à pouvoir appliquer une polarisation et conduire le signal de sortie, caractérisé en ce que ledit corps est formé d'une pluralité de couches variant par degrés (2 à 6), sensibles à des énergies lumineuses différentes, chacune ayant une épaisseur de l'ordre de la longueur d'absorption de la longueur d'onde de la lumière incidente que doit absorber cette couche particulière, la bande interdite diminuant par une suite de degrés dont la variation dominante est celle de la bande de conduction ou bien de la bande de valence selon le type particulier (électrons ou trous) de porteurs de charge que l'on veut favoriser, de telle sorte que l'énergie soit principalement transférée à ce porteur dominant, chaque échelon étant tel que la quasi-totalité de la transition ait lieu sur une distance inférieure au parcours libre moyen de ce porteur.

2. Le photodétecteur de la revendication 1, dans lequel les porteurs de charge favorisés sont les électrons, la discontinuité de la bande de conduction étant supérieure à la discontinuité de bande de valence à l'endroit de chacun desdits degrés.

3. Le photodétecteur de la revendication 1, dans lequel les porteurs de charge favorisés sont les trous, la discontinuité de la bande de valence étant notablement supérieure à la discontinuité de bande de conduction à l'endroit de chacun desdits degrés.

4. Le photodétecteur de la revendication 2, dans lequel le corps semiconducteur est formé de $(In_xGa_{1-x})As$, x variant entre 0 et 1 part incréments d'environ 0,25.

5. Le photodétecteur de la revendication 2, dans lequel le corps semiconducteur est formé de $Ga(Sb_xAs_{1-x})$, x variant entre 0 et 1 par incréments d'environ 0,25.

6. Le photodétecteur de l'une des revendications précédentes, dans lequel chaque transition de la bande interdite a lieu dans les limites de 5 nm.

EP 0 127 724 B1

FIG. 1

FIG. 2